# EUROPEAN PATENT SPECIFICATION

(11) **EP 4 444 674 B1**
(45) Date of publication and mention of the grant of the patent: **24.12.2025**
(21) Application number: 23800670.4
(22) Date of filing: 29.09.2023
(51) Int. Cl.: H01L 23/373, C04B 37/02, H01L 23/495, H01L 23/051, H01L 23/31, H01L 23/433

(54) **INTEGRATED SUBSTRATES AND RELATED METHODS**
INTEGRIERTE SUBSTRATE UND ZUGEHÖRIGE VERFAHREN
SUBSTRATS INTÉGRÉS ET PROCÉDÉS ASSOCIÉS

(30) Priority: 05.10.2022 US 202263378391 P; 06.10.2022 US 202263378628 P; 13.03.2023 US 202318182552
(43) Date of publication of application: 16.10.2024
(73) Proprietor: Semiconductor Components Industries, LLC, Scottsdale, AZ 85250 (US)
(72) Inventor: JEON, Oseob, Seoul Seoul 06518 (KR); KANG, Dongwook, Gyeonggi- do 14643 (KR); IM, Seungwon, Gyeonggi-do 14533 (KR); KIM, Jihwan, Seoul Seoul 15094 (KR)
(74) Representative: Manitz Finsterwald Patent- und Rechtsanwaltspartnerschaft mbB
(86) International application number: PCT/US2023/075599
(87) International publication number: WO 2024/076880

(56) References cited:
- WO-A1-2022/019089
- US-A1- 2013 279 119
- US-A1- 2014 293 548
- US-A1- 2014 367 702
- US-A1- 2018 261 520
- US-A1- 2022 122 905

## Description

### BACKGROUND

### 1. Technical Field

Aspects of this document relate generally to substrates, such as substrates for semiconductor packages.

Document WO 2022/019089 A1 1 discloses an integrated substrate according to the preamble of claim 1 and a method of forming an integrated substrate according to the preamble of claim 8. Documents US 2018/261520 A1, US 2014/367702 A1 US 2022/122905 A1, US 2014/293548 A1 and US 2013/279119 A1 disclose related substrates and methods.

### 2. Background

Semiconductor packages work to provide mechanical support for semiconductor die and to allow them to be coupled with sockets, motherboards, or other components. Semiconductor packages also have been devised that allow for protection of the semiconductor die from humidity and electrostatic discharge effects.

### SUMMARY

An integrated substrate may include a conductor layer; a heat sink including a plurality of fins extending therefrom; and a dielectric layer including boron nitride chemically bonded to the conductor layer and to the heat sink with an epoxy.

Implementations of an integrated substrate may include one, all, or any of the following:

The thermal resistance of the integrated substrate may be lower than a direct bonded copper substrate including silicon nitride.

The integrated substrate may include a spacer coupled to the conductor layer.

The integrated substrate may include a semiconductor die coupled to the conductor layer.

The integrated substrate may include a mold compound coupled to the conductor layer, the heat sink, and the dielectric layer.

The integrated substrate may include one or more electrical connectors electrically coupled with the conductor layer.

The integrated substrate may include a second conductor layer, a second heat sink, and a second dielectric layer including boron nitride coupled with a semiconductor die coupled with the conductor layer.

The boron nitride of the dielectric layer may be a filler in a sheet of epoxy resin.

The dielectric layer may be sufficiently flexible to be folded in half.

Implementations of a method of forming an integrated substrate may include providing a conductor layer and a heat sink including a plurality of fins extending therefrom; and chemically bonding a dielectric layer including boron nitride to the conductor layer and to the heat sink with an epoxy.

Implementations of a method of forming an integrated substrate may include one, all, or any of the following:

The method may include patterning the conductor layer to form a plurality of traces therein.

The method may include a coupling a spacer to the conductor layer.

The method may include coupling a semiconductor die to the conductor layer.

The method may include applying a mold compound to the conductor layer, the heat sink, and the dielectric layer and electrically coupling one or more electrical connectors with the conductor layer.

Implementations of a method of forming an integrated substrate may include providing a conductor layer; machining a pattern corresponding with one or more traces into the conductor layer; and coupling the conductor layer and a heat sink to a dielectric substrate. The method may include, after coupling the conductor layer to the dielectric substrate, etching the conductor layer to form the one or more traces.

Implementations of a method of forming an integrated substrate may include one, all, or any of the following:

Coupling the conductor layer and the heat sink further may include active metal brazing.

The method may include coupling one or more spacers with the conductor layer using active metal brazing. Coupling the conductor layer and the heat sink further may include active metal brazing.

Coupling the conductor layer and the heat sink to the dielectric substrate further may include where the dielectric substrate includes boron nitride.

The method may include transfer molding a mold compound over the one or more traces, the dielectric substrate, and the heat sink.

Machining the pattern further includes removing between 90 percent and 95 percent of a thickness of the conductor layer to form the pattern.

The foregoing and other aspects, features, and advantages will be apparent to those artisans of ordinary skill in the art from the DESCRIPTION and DRAWINGS, and from the CLAIMS.

### BRIEF DESCRIPTION OF THE DRAWINGS

Implementations will hereinafter be described in conjunction with the appended drawings, where like designations denote like elements, and:
FIG. 1 is a series of drawings showing side cross sectional views of an integrated substrate at four points during an implementation of a method of forming an integrated substrate;
FIG. 2 is a cross sectional view of an implementation of an integrated substrate showing two spacers coupled thereto;
FIG. 3 is a cross sectional view of an implementation of semiconductor package that includes an integrated substrate and mold compound coupled thereto;
FIG. 4 is a cross sectional view of another implementation of a semiconductor package that includes two integrated substrates and mold compound coupled thereto;
FIG. 5 is a cross sectional detail view of an implementation of an etched trace;
FIG. 6 is a cross sectional view of an implementation of an integrated substrate formed using active metal brazing to a ceramic dielectric layer;
FIG. 7 is a cross sectional view of another implementation of an integrated substrate that includes a dielectric layer that includes boron nitride;
FIG. 8 is a cross sectional view of an implementation of an integrated substrate at a first point in an implementation of a method of forming an integrated substrate;
FIG. 9 is a cross sectional view of the implementation of the integrated substrate of FIG. 8 following milling, etching, and plating processes;
FIG. 10 is a cross sectional view of an implementation of a semiconductor package that includes an integrated substrate and mold compound coupled thereto; and
FIG. 11 is a cross sectional view of another implementation of a semiconductor package that includes two integrated substrates and mold compound coupled thereto.

### DESCRIPTION

Direct bond copper (DBC) substrates are used to electrically couple and mechanically hold semiconductor die in place in a semiconductor package and facilitate the connection of various electrical connectors with semiconductor die. In various package implementations, the DBC substrate also has a heat sink bonded to the copper layer on the side of the substrate that does not have semiconductor coupled thereto. The bonding methods used to attach the heatsink to the copper layer include soldering or sintering. Because soldering involves adding an additional metal layer between the heat sink and the DBC substrate, it adds significantly to the cost of the package and large voids in the solder layer have been observed to consistently be present in the layer post-soldering, increasing thermal resistance in these areas. Sintering the heat sink to the DBC substrate has been observed to regularly result in cracking of the ceramic dielectric portion of the DBC substrate due to the high temperatures and pressures used in sintering processes, where the ceramic dielectric portion includes aluminum oxide or zirconia toughened oxide. Sintering is also a process that can add significant cost to the package formation process. Furthermore, because of the differences in thickness between the first copper layer in the DBC on the opposite side of the dielectric layer from the second copper layer soldered/sintered to the heatsink, warpage of the DBC substrate has been observed to occur unless the first copper layer is thicker than 0.8 mm. Also, when traces are formed in the first copper layer, the spacing between the traces to avoid warping beyond a manufacturable level has been observed to be 2 mm where 1 mm thick copper is used for the first copper layer. This requirement of 2 mm spaced traces limits the ability to include semiconductor die of larger sizes on form the same size of DBC substrate.

Two integrated substrate implementations and related methods are disclosed in this document that structurally differ from DBC substrates in two different ways. In a first implementation, the heat sink is directly coupled to the dielectric layer and not to a second copper layer as when a DBC substrate is used, while a conductor layer is coupled to the opposing side of the dielectric layer, forming an integrated substrate. In a second implementation, a dielectric layer that includes boron nitride is used instead of a ceramic substrate that includes, by non-limiting example, aluminum oxide, aluminum oxide, zirconia oxide, or beryllium oxide. In implementations of methods of making both integrated substrates, other methods of bonding/coupling the dielectric layer with the conductor layer and heat sink that do not include soldering or sintering are disclosed.

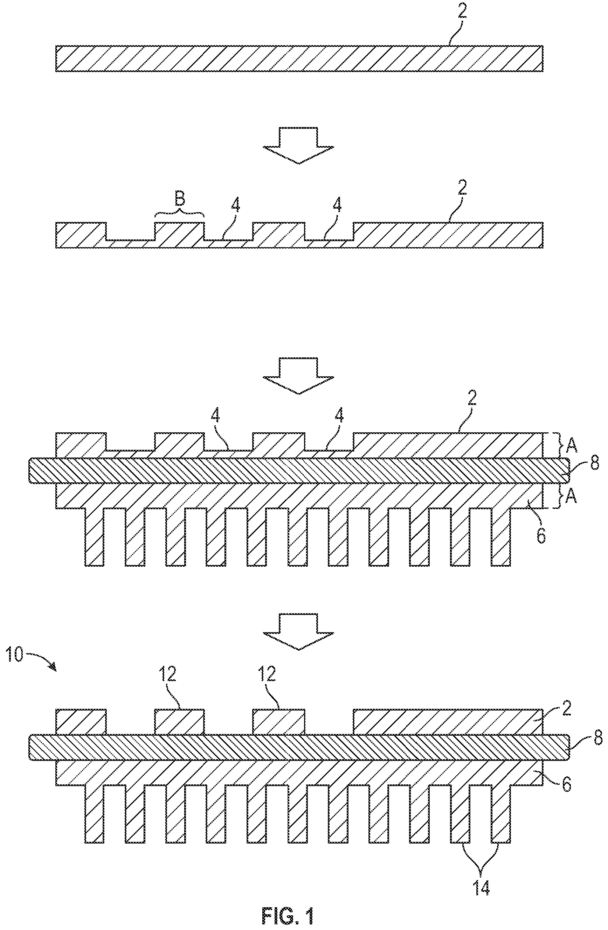

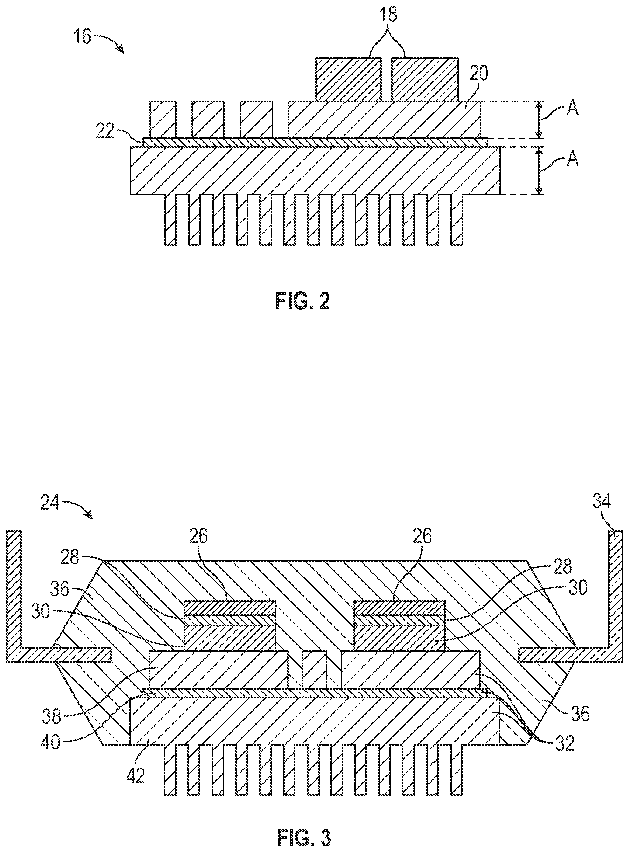

Referring to FIG. 1, a series of drawings is illustrated showing side cross sectional views of an integrated substrate at four points during an implementation of a method of forming an integrated substrate is illustrated. As illustrated, conductor layer 2 is illustrated which has a thickness between about 0.8 mm to about 1.2 mm. As illustrated in FIG. 1 (and with reference to FIG. 2), the thickness of the conductor layer 2 (distance A) can be matched to the thickness of the largest planar portion of a heat sink 6 coupled to dielectric layer 8 (also distance A). The conductor layer 2 is then illustrated following machining of channels 4 into the material of the conductor layer. About 90 percent to about 95 percent of the thickness of the conductor layer 2 are removed during the machining process. In various implementations, the machining may take place using a computer numerical control (CNC) machining process. Because of the integration of the substrate structure, a minimum spacing B between adjacent channels can be about 1 mm (rather than the 2 mm observed for DBC substrates). This closer spacing can allow for larger/more die to be coupled to the integrated substrate for the same sized substrate.

FIG. 1 shows the machined conductor layer 2 coupled to dielectric layer 8 and heat sink 6 forming an integrated substrate where the heat sink is fully integrated by forming the second metal coupled to the dielectric layer 8. In particular method implementations, the conductor layer 2 and heat sink 6 are coupled using an active metal brazing process. Because active metal brazing does not generally involve the use of solder or other metallization to form the bond between the material of the machined conductor layer 2 and the heat sink, the costs and the observed voiding of the solder process are avoided. Furthermore, the cost and dielectric layer fracturing issues associated with sintering caused by the high temperature and pressure can also be avoided.

The flow illustrated in FIG. 1 finishes with integrated substrate 10 following an etching process that removes the remaining about 5% to about 10% of the material in the channels forming one or more traces 12 in the conductor layer 2 and exposing the material of the dielectric layer 8. The etching process used in various implementations may be any of a wide variety of processes, including, by non-limiting example, wet etching, dry etching, chemical etching, lasering, any combination thereof, or any other removal process capable of selectively removing the material of the conductor layer 2. As illustrated in FIG. 1, the heat sink 6 includes a plurality of fins 14 extending therefrom substantially perpendicular to the largest planar surface of the heat sink 6. However, in various implementations, heat sinks of a wide variety of types may be employed that include, by non-limiting example, folded fins, fins, pins, skived fins, or any other heat sink projection type. In various implementations, the projections of the heat sink 6 may be formed prior to coupling to the dielectric layer 8; in other implementations the projections of the heat sink 6 may be formed after coupling to the dielectric layer 8. A wide variety of methods may be employed to form the projections of the heat sinks disclosed herein including by non-limiting example, casting, machining, skiving, molding, or any other method used to form a thermally conductive material.

Referring to FIG. 2, an implementation of an integrated substrate 16 formed using the method of FIG. 1 is illustrated following coupling of two spacers 18 to the surface of the conductor layer 20. In various method implementations, the spacers 18 can be coupled to the conductor layer 20 using active metal brazing either at the same time the conductor layer 20 is coupled to the dielectric layer 22 or in a separate active metal brazing step. The use of spacers may be used where the semiconductor package is intended to include double sided cooling via the use of two heat sinks. The spacers may be formed of various materials, including, by non-limiting example, copper, aluminum, copper alloys, aluminum alloys, metals, ceramics, or any other mechanically stiff material capable of electrically/thermally coupling with a semiconductor die and supporting it.

FIG. 3 illustrates a cross sectional view of an implementation of a semiconductor package 24 following additional packaging steps, including die mounting/bonding of semiconductor die 26 using die bonding material 28 to spacers 30. In various method implementations, the placement of clips and/or wirebonding (not shown in FIG. 3) may also be employed to form additional connections to the semiconductor die 26, the integrated substrate 32, and/or to electrical connectors 34 that are illustrated as extending out from mold compound 36 that covers/contacts the integrated substrate components (conductor layer 38, dielectric layer 40, and heat sink 42). In the various method implementations, a molding process and post-mold-cure (PMC) process are used to apply the mold compound. In various implementations, transfer molding may be used to apply the mold compound. In various package formation methods additional operations may be employed, including laser marking, electroplating of the leads (with tin and with nickel in a particular implementation), and testing of the electrical function of the package.

Any of a wide variety of semiconductor die may be used in combination with the various integrated substrates disclosed herein, including, by non-limiting example, a silicon die, a silicon-on-insulator die, a silicon carbide die, a gallium arsenide die, a power semiconductor die, a metal oxide field effect transistor (MOSFET) die, an insulated gate bipolar transistor (IGBIT), a diode, a rectifier, a thyristor, or any other semiconductor device type formed on any other semiconductor material type. A wide variety of combinations of semiconductor die and semiconductor packages may be constructed with the integrated substrate implementations disclosed herein using the principles disclosed.

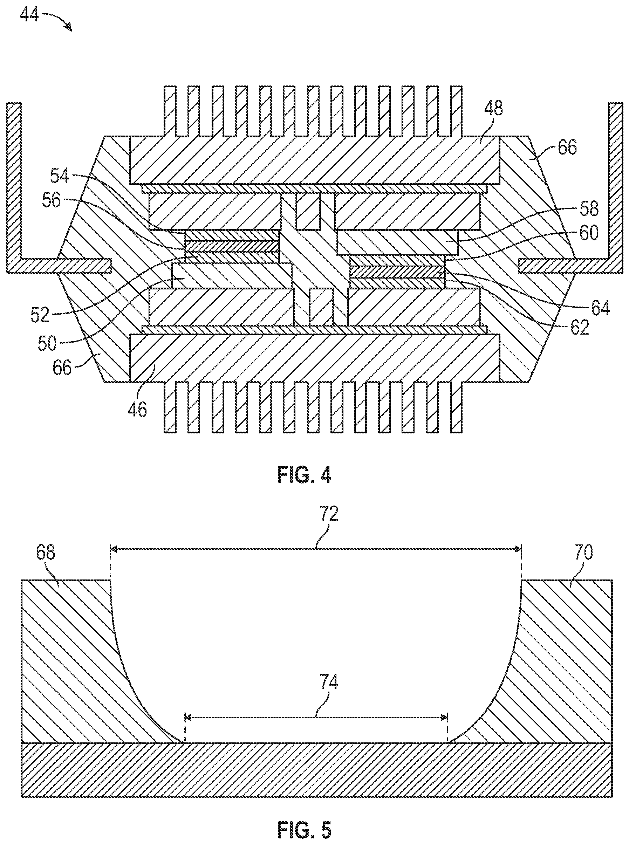

Referring to FIG. 4, an implementation of a semiconductor package 44 that includes a first integrated substrate 46 and a second integrated substrate 48 is illustrated. The structure of the first integrated substrate 46 and the second integrated substrate 48 are similar to those previously discussed in this document. The first and second integrated substrates 46, 48 are joined through the illustrated arrangement of first spacer 50 and die bonding layers 52, 54 which bond semiconductor die 56 between the substrates. Similarly, second spacer 58, die bonding layers 60, 62 coupled semiconductor die 64 to the first and second integrated substrates 46, 48. Similar to the semiconductor package implementation in FIG. 3, mold compound 66 has been applied over the various components of the first integrated substrate 46 and second integrated substrate 48. As with the implementation illustrated in FIG. 3, additional clips/wirebonds or other structures (not shown in FIG. 4) may be used to electrically connect connectors 68 (see Fig. 5) to the semiconductor die 56, 64; the first integrated substrate 46; and/or the second integrated substrate 48.

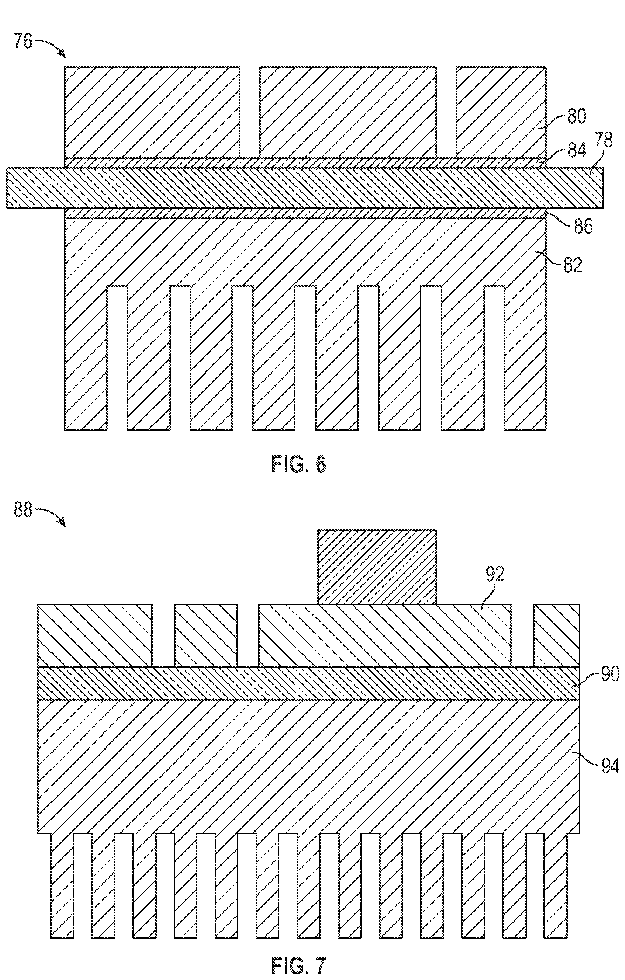

Referring to FIG. 5, a detail cross sectional view of an implementation of a space between traces/etched traces 68, 70 is illustrated. As illustrated, the space includes a head measure 72 and a bottom measure 74. The curved edges of the traces 68, 70 indicates that the space illustrated in FIG. 6 is currently under etched as the head measure 72 is wider/larger than the bottom measure 74. Table 1 shows a non-limiting example of minimum head measures and minimum bottom measures after the machining process and after the subsequent etching processes are completed. Note that the general trend is that the bottom measure is larger/wider than the head measure, indicating an over etch condition exists at the end of the etching process. All of the values in the table are in millimeters and the header row of the table is the thickness of the conductor layer in millimeters.

**Table 1**

| | **0.5 Cu** | | **0.8 Cu** | | **1.0 Cu** | | **1.2 Cu** | |
|---|---|---|---|---|---|---|---|---|
| | Head | Bottom | Head | Bottom | Head | Bottom | Head | Bottom |
| **Post-Machining** | 0.6 | 0.6 | 1.0 | 1.0 | 1.0 | 1.0 | 1.0 | 1.0 |
| **Post-Etching** | 1.0 | 1.5 | 1.2 | 2.0 | No data | No data | No data | No data |

While Table 1 illustrates a set of post-machining and post-etching head measure and bottom measure values for an integrated substrate implementation that includes copper, other values may exist for other copper-containing implementations and for other conductor types, such as, by non-limiting example, copper alloys, aluminum, aluminum alloys, or any other electrical conductor type. A wide variety of machining and etching head and bottom measures may be constructed using the principles disclosed herein.

Referring to FIG. 6, an implementation of an integrated substrate 76 formed using the method implementations previous discussed that involve active metal brazing is illustrated. The integrated substrate 76 includes dielectric layer 78, conductor layer 80, and heat sink 82 and FIG. 6 illustrates brazed regions 84, 86 in the material of each of the layers. The brazed regions 84, 86 are formed during the active metal brazing process and are the portions of the various layers that serve to bond the layers together. One of the challenges of the brazed regions 84, 86 is that in various implementations, the coefficient of thermal expansion (CTE) and/or the heat transfer coefficient of the material in the brazed regions is different from the CTE and heat transfer coefficients of the dielectric layer 78, conductor layer 80, and/or the heat sink 82. Because of this, the brazed regions 84, 86 may negatively impact either or both of the CTE and heat transfer performance of the integrated substrate itself.

FIG. 7 illustrates an implementation of a second type of an integrated substrate 88 that employs a dielectric layer 90 that includes boron nitride. As illustrated, the integrated substrate 88 also includes a conductor layer 92 and heat sink 94. In various substrate implementations, the conductor layer 92 may be patterned using any of the previously discussed methods of machining and etching. However, in other implementations, other patterning methods may be employed to form the pattern, such as, by non-limiting example, photolithographic patterning and etching or lasering. Similar to the integrated substrate implementations previously disclosed, one or more spacers may be coupled to the conductor 92.

In a particular implementation, the dielectric layer 90 may be a sheet of epoxy resin that include boron nitride particles as filler. The coefficient of thermal expansion of this implementation of dielectric layer may be about 17-19 ppm and thermal conductivity may be about 16.5 W/K which may enable comparable or better thermal resistance performance to the ceramic dielectric layer materials disclosed previously in this document. In various implementations, because the dielectric layer 90 is made of a sheet of epoxy resin, the layer is flexible enough to allow it to be folded in half/folded back onto itself. Such a dielectric layer 90 material is quite different from the rigid ceramic dielectric layer materials previously discussed in this document and thus has significant mechanical flexibility advantages. For example, the use of the boron nitride-containing dielectric layer may enable the use of common mold compounds with CTEs of about 14-17 ppm for the molding process which may lower the overall package cost. Also, the boron nitride-containing dielectric layer may demonstrate higher thermal conductivity and breakdown voltage than a ceramic dielectric material containing aluminum oxide or aluminum nitride in an insulated metal substrate (IMS) design. This result may be observed particularly when the dielectric layer is formed as an integrated substrate where the heat sink is integrated with the dielectric layer as in the implementation in FIG. 7.

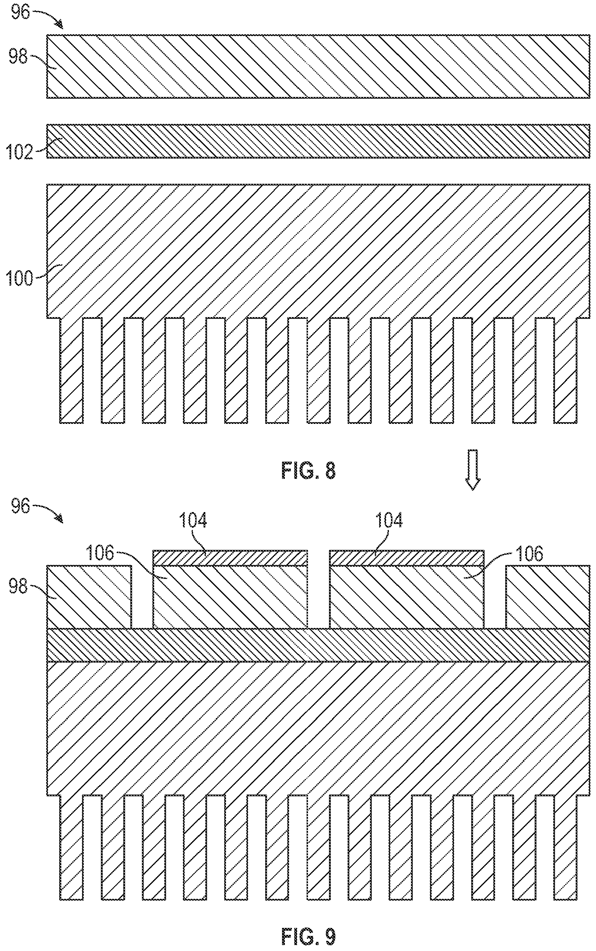

Referring to FIG. 8, an implementation of an integrated substrate 96 is illustrated in an exploded view during an implementation of a method of forming an integrated substrate. As illustrated, a conductor layer 98 (which may be any conductor layer type disclosed herein) is provided along with heat sink 100 (which may be any heat sink type disclosed herein). Dielectric layer 102 is also provided which contains boron nitride (which may be any boron nitride-containing dielectric layer disclosed herein). The dielectric layer 102 then has an epoxy resin applied to each of its largest planar surfaces and the conductor layer 98 and heat sink 100 are placed in contact with the dielectric layer 102 until the epoxy resin has cured/adhered/bonded the layers and heat sink together. Referring to FIG. 9, the integrated substrate 96 is illustrated following patterning via an etching process and electroplating of layers 104 over portions of conductor layer 98. The method implementation illustrated in FIGS. 8-9, an etch patterning process is utilized that may involve photolithographic patterning, stencil patterning, screen printing, or other methods of protecting the material of the conductor layer 98 during etching. However, in other method implementations, the process of machining the conductor layer 98 previously disclosed herein may be first performed prior to the bonding of the dielectric layer 102 to the conductor layer 98. Then the etching process previously disclosed may be employed to form the one or more traces 106 in the material of the conductor layer 98, which may involve protective patterning or may not include protective patterning in various method implementations.

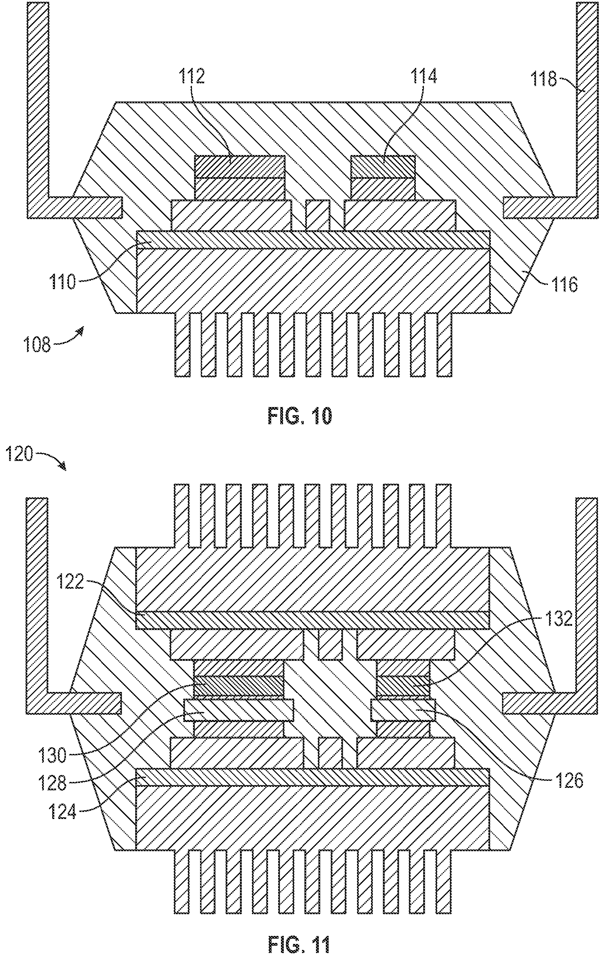

With the integrated substrate formed, the substrate can now be used in any of the previously disclosed method implementations that involve semiconductor die attach, wire bonding, clip attach, molding, transfer molding, post-mold-cure, laser marking, electroplating, and/or testing operations to form a semiconductor package. FIG. 10 illustrates a semiconductor package 108 that includes an integrated substrate with a dielectric layer 110 that includes boron nitride that includes semiconductor die 112, 114 and which includes mold compound 116 that contacts the various components of the integrated substrate. This package includes similar die bonding layers and electrical connections to the electrical connectors 118 included in the package that electrically couple the semiconductor die 112, 114 and/or the integrated substrate to the electrical connectors 118. FIG. 11 illustrates a semiconductor package 120 that includes two integrated substrates with boron nitride containing dielectric layers 122, 124. Like the implementation illustrated in FIG. 4, this package includes spacers 126, 128, but these spacers are attached to just one of the integrated substrates while the semiconductor die 130, 132 are attached to the other integrated substrate. This package also contains electrical connectors 134 which are electrically connected to the semiconductor die 130, 132 and/or the integrated substrates through wirebonds/clips, etc. similar to the implementations previously disclosed herein.

## Claims

1. An integrated substrate (88) comprising:
a conductor layer (92);
a heat sink (94) comprising a plurality of fins extending therefrom; and
a dielectric layer (90) comprising boron nitride chemically bonded to the conductor layer (92) and to the heat sink (94) with an epoxy,
wherein
the conductor layer is formed from a conductor layer having an initial thickness between 0.8 mm to 1.2 mm from which between 90 percent and 95 percent of the thickness were removed by machining.

2. The integrated substrate (88) of claim 1, wherein a thermal resistance of the integrated substrate (88) is lower than a direct bonded copper substrate comprising silicon nitride.

3. The integrated substrate (88) of claim 1, further comprising a spacer (126) coupled to the conductor layer (92).

4. The integrated substrate (88) of claim 1, further comprising one or more electrical connectors (118) electrically coupled with the conductor layer (92).

5. The integrated substrate (88) of claim 1, further comprising a second conductor layer, a second heat sink, and a second dielectric layer (124) comprising boron nitride coupled with a semiconductor die (114) coupled with the conductor layer.

6. The integrated substrate (88) of claim 1, wherein the boron nitride of the dielectric layer (90) is a filler in a sheet of epoxy resin.

7. The integrated substrate (88) of claim 8, wherein the dielectric layer (90) is sufficiently flexible to be folded in half.

8. A method of forming an integrated substrate (16) comprising:
providing a conductor layer (2);
machining a pattern corresponding with one or more traces (12) into the conductor layer (2);
coupling the conductor layer (2) and a heat sink (6) to a dielectric substrate (8);
after coupling the conductor layer (2) to the dielectric substrate (8), etching the conductor layer (2) to form the one or more traces (12),
wherein
machining the pattern further comprises removing between 90 percent and 95 percent of a thickness of the conductor layer (2) to form the pattern.

9. The method of claim 8, wherein coupling the conductor layer (2) and the heat sink (6) further comprises active metal brazing.

10. The method of claim 8, further comprising coupling one or more spacers (18) with the conductor layer (2) using active metal brazing and wherein coupling the conductor layer (2) and the heat sink (6) further comprises active metal brazing.

## Patentansprüche

1. Integriertes Substrat (88), umfassend:
eine Leiterschicht (92);
eine Wärmesenke (94), die eine Vielzahl von Rippen umfasst, die sich davon erstrecken; und
eine dielektrische Schicht (90), die Bornitrid umfasst, das mit einem Epoxid chemisch an die Leiterschicht (92) und an die Wärmesenke (94) gebunden ist,
wobei die Leiterschicht aus einer Leiterschicht gebildet ist, die eine anfängliche Dicke zwischen 0,8 mm und 1,2 mm aufweist, von der zwischen 90 Prozent und 95 Prozent der Dicke durch maschinelle Bearbeitung entfernt wurden.

2. Integriertes Substrat (88) nach Anspruch 1, wobei ein Wärmewiderstand des integrierten Substrats (88) niedriger ist als ein direkt gebundenes Kupfersubstrat, das Siliziumnitrid umfasst.

3. Integriertes Substrat (88) nach Anspruch 1, ferner umfassend einen Abstandshalter (126), der mit der Leiterschicht (92) gekoppelt ist.

4. Integriertes Substrat (88) nach Anspruch 1, ferner umfassend einen oder mehrere elektrische Verbinder (118), die elektrisch mit der Leiterschicht (92) gekoppelt sind.

5. Integriertes Substrat (88) nach Anspruch 1, ferner umfassend eine zweite Leiterschicht, eine zweite Wärmesenke und eine zweite dielektrische Schicht (124), die Bornitrid umfasst, das mit einem Halbleiterchip (114) gekoppelt ist, der mit der Leiterschicht gekoppelt ist.

6. Integriertes Substrat (88) nach Anspruch 1, wobei das Bornitrid der dielektrischen Schicht (90) ein Füllstoff in einer Lage aus Epoxidharz ist.

7. Integriertes Substrat (88) nach Anspruch 8, wobei die dielektrische Schicht (90) ausreichend flexibel ist, um zur Hälfte gefaltet zu werden.

8. Verfahren zum Bilden eines integrierten Substrats (16), umfassend:
Bereitstellen einer Leiterschicht (2);
maschinelles Einarbeiten eines Musters, das einer oder mehreren Leiterbahnen (12) entspricht, in die Leiterschicht (2);
Koppeln der Leiterschicht (2) und einer Wärmesenke (6) an ein dielektrisches Substrat (8);
nach dem Koppeln der Leiterschicht (2) an das dielektrische Substrat (8), Ätzen der Leiterschicht (2), um die eine oder die mehreren Leiterbahnen (12) zu bilden,
wobei das maschinelle Einarbeiten des Musters ferner das Entfernen zwischen 90 Prozent und 95 Prozent einer Dicke der Leiterschicht (2) umfasst, um das Muster zu bilden.

9. Verfahren nach Anspruch 8, wobei das Koppeln der Leiterschicht (2) und der Wärmesenke (6) ferner Aktivmetall-Hartlöten umfasst.

10. Verfahren nach Anspruch 8, ferner umfassend das Koppeln eines oder mehrerer Abstandshalter (18) mit der Leiterschicht (2) unter Verwendung von Aktivmetall-Hartlöten und wobei das Koppeln der Leiterschicht (2) und der Wärmesenke (6) ferner Aktivmetall-Hartlöten umfasst.

## Revendications

1. Substrat intégré (88) comprenant :
une couche conductrice (92) ;
un dissipateur thermique (94) comprenant une pluralité d'ailettes s'étendant à partir de celui-ci ; et
une couche diélectrique (90) comprenant du nitrure de bore lié chimiquement à la couche conductrice (92) et au dissipateur thermique (94) avec un époxy,
dans lequel
la couche conductrice est formée à partir d'une couche conductrice ayant une épaisseur initiale comprise entre 0,8 mm et 1,2 mm, dont 90 à 95 % de l'épaisseur ont été retirés par usinage.

2. Substrat intégré (88) selon la revendication 1, dans lequel la résistance thermique du substrat intégré (88) est inférieure à celle d'un substrat en cuivre à liaison directe comprenant du nitrure de silicium.

3. Substrat intégré (88) selon la revendication 1, comprenant en outre un espaceur (126) couplé à la couche conductrice (92).

4. Substrat intégré (88) selon la revendication 1, comprenant en outre un ou plusieurs connecteurs électriques (118) couplés électriquement à la couche conductrice (92).

5. Substrat intégré (88) selon la revendication 1, comprenant en outre une deuxième couche conductrice, un deuxième dissipateur thermique et une deuxième couche diélectrique (124) comprenant du nitrure de bore couplée à une puce semi-conductrice (114) couplée à la couche conductrice.

6. Substrat intégré (88) selon la revendication 1, dans lequel le nitrure de bore de la couche diélectrique (90) est une charge dans une feuille de résine époxy.

7. Substrat intégré (88) selon la revendication 8, dans lequel la couche diélectrique (90) est suffisamment flexible pour être pliée en deux.

8. Procédé de formation d'un substrat intégré (16) comprenant :
la fourniture d'une couche conductrice (2) ;
l'usinage d'un motif correspondant à une ou plusieurs pistes (12) dans la couche conductrice (2) ;
le couplage de la couche conductrice (2) et d'un dissipateur thermique (6) à un substrat diélectrique (8) ;
après le couplage de la couche conductrice (2) au substrat diélectrique (8), le gravage de la couche conductrice (2) pour former lesdites une ou plusieurs pistes (12),
dans lequel
l'usinage du motif comprend en outre le retrait de 90 à 95 % de l'épaisseur de la couche conductrice (2) pour former le motif.

9. Procédé selon la revendication 8, dans lequel le couplage de la couche conductrice (2) et du dissipateur thermique (6) comprend en outre un brasage métallique actif.

10. Procédé selon la revendication 8, comprenant en outre le couplage d'un ou plusieurs espaceurs (18) à la couche conductrice (2) à l'aide d'un brasage métallique actif, et dans lequel le couplage de la couche conductrice (2) et du dissipateur thermique (6) comprend en outre un brasage métallique actif.
